# EUROPEAN PATENT APPLICATION

(11) **EP 1 056 323 A1**
(43) Date of publication of application: **29.11.2000**
(21) Application number: 99304029.4
(22) Date of filing: 25.05.1999
(51) Int. Cl.: H05K 7/20

(54) **Cooling unit using pressure differential**

(71) Applicant: LUCENT TECHNOLOGIES INC., Murray Hill, New Jersey 07974-0636 (US)
(72) Inventor: Falaki, Hamid Reza, Swindon, Wiltshire SN5 5AA (GB); Hussain, Nayyar, Swindon, Wiltshire SN5 9FG (GB); Sparkes, Stephen David, Cove, Farnborough, Hants GU14 0HX (GB)
(74) Representative: Williams, David John

(57) **Abstract**

There is disclosed a cooling module comprising a housing having an opening in a top and a bottom thereof. A fan is provided in the top of the housing to promote the flow of air from the bottom to the top. The housing is further provided with at least one opening in a side thereof for facilitating the flow of air external to the housing. A pressure differential is thereby created in a region external to the housing below the at least one opening. An additional air flow is facilitated along the external side of the housing by said pressure differential.

## Description

### Field of the Invention

The present invention relates to housings provided with fan means for promoting a flow of air to assist in cooling of the housing, and particularly but not exclusively to such housings containing electronic devices.

### Background to the Invention

An example of an environment where severe heat conditions can effect the operation of electronic components, and therefore were adequate cooling arrangements need to be provided, is in the base station of a mobile communications system. A circuit board in such a base station typically has a number of integrated circuits at the extremes of their operating thermal design limit when the system experiences the harshest environmental conditions.

It is required to increase the thermal margin in order to increase the product reliability, by having critical integrated circuits running cooler.

The desire to run the integrated circuits at cooler temperatures must be achieved by a combination of techniques. Integrated circuits should preferably be provided with heat sinks to reduce the temperatures on the integrated circuits locally. In addition, the unit housing the electronic circuitry should preferably be provided with effective general cooling means such as a fan to keep the whole unit cool.

Typically a fan unit is positioned on top of a housing. The housing has an opening at the bottom and openings at the top, and the arrangement is such that the fan draws air in at the bottom of the housing and expels it at the top. The air is thus drawn through the housing across the electronic modules/components contained therein. The quicker the air can be drawn through the housing then the cooler the temperature of the components contained therein, and the less the variation in temperature at points in the housing between the bottom and the top.

It is an object of the present invention to provide a means for providing an additional air flow in a housing which is provided with a fan for promoting a flow of air.

### Summary of the Invention

According to the present invention there is provided a cooling module comprising a housing having an opening in a top and a bottom thereof, a fan being provided in the top of the housing to promote the flow of air from the bottom to the top, the housing further being provided with at least one opening in a side thereof for facilitating a flow of air external to the housing, wherein a pressure differential is thereby created in a region external to the housing below the at least one opening, whereby an additional air flow is facilitated along the external side of the housing by said pressure differential.

The at least one opening preferably provides a high velocity air flow. The at least one opening is preferably angled to provide a high velocity air flow. The at least one opening is preferably a louver opening.

The housing is preferably provided with physical means external thereto forming a channel for the additional air flow. The physical means preferably comprises a series of protruding fins. The physical means preferably comprises a solar panel, a channel being formed between the panel and the side of the housing.

### Brief Description of the Figures

Figure 1(a) and 1(b) illustrate front and side views of a conventional housing including a fan for promoting a flow of air; and
Figures 2(a) and 2(b) illustrate a side view and an exploded side view of a housing according to the present invention modified to promote an additional flow of air.

### Description of the Preferred Embodiment

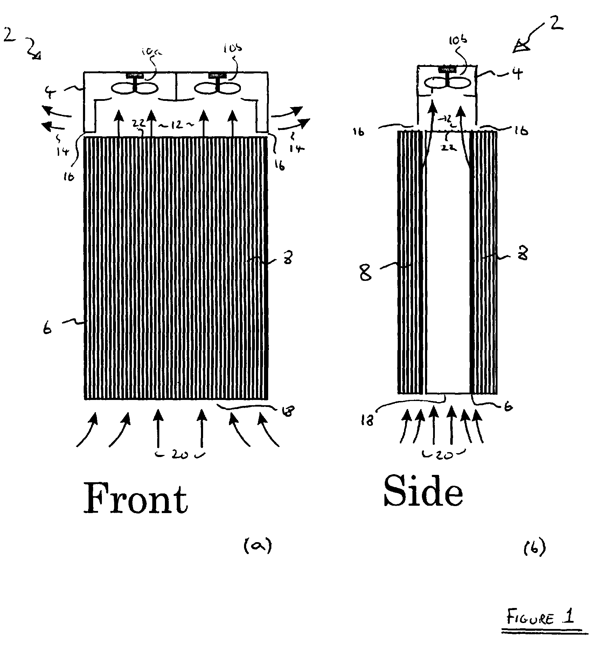

Referring to Figures 1(a) and (b) there is illustrated front and side views respectively of a module comprising the base station of a mobile communications system which utilises a conventional fan cooling technique.

The module 2 comprises a main housing 6 which houses all the functional elements of the base station, and a cooling unit 4 mounted on top of, and fixed to, the housing 6. The cooling unit 4 is removably attached to the housing 6, and may therefore be dispensed with in environments where it can be guaranteed that conditions are such that the cooling means will not need to be utilised. The housing 6 is preferably provided with a plurality of fins 8 along the front and back sides thereof. The fins provide a means for dissipating heat from the module 2.

The housing 6 has an opening 18 at the bottom thereof and an opening 22 at the top thereof, such that air can flow from the bottom of the housing to the top of the housing and aid in the cooling of the module 2. The cooling unit 4 is provided with two fans 10a and 10b.

In operation, in order to cool the module 2 the fans 10a and 10b, when switched on, draw air through the housing 6. The air is drawn from the bottom of the housing 18 as indicated by the arrows 20, through the centre of the housing, and into the cooling unit 4 as indicated by the arrows 12.

The air is expelled from the cooling unit 4 via openings provided between the cooling unit 4 and the housing 6, as indicated by the arrows 14. The openings for expelling the air from the cooling unit 4 may be provided along all four sides of the module or along selected sides. The openings for expelling air are conventionally not well-defined, and may be of variable size and shape.

The openings 16 provide an intake for an additional flow of air. Provision of the openings 16 for the intake of air remove hot air from the region external to the housing 6, and generally assist in the cooling of the unit.

The arrows 12 also indicate a transfer of heat from the fins 8 into the air flow within the housing facilitated by the fans 10a and 10b.

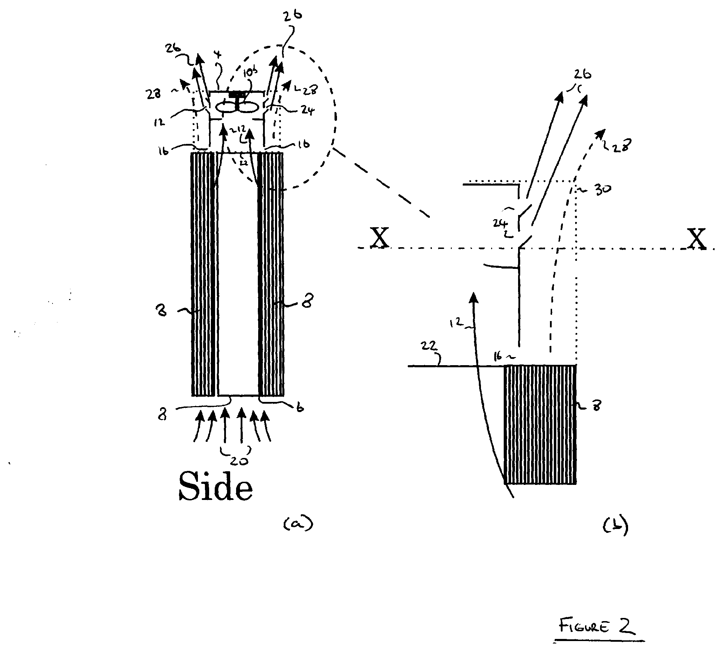

Referring to Figures 2(a) and 2(b) there is illustrated the module 2 of Figure 1 adapted to incorporate the technique of the present invention.

The housing 6 is constructed identically as before, and the cooling unit 4 including the fans 10a and 10b placed on top of the housing as before.

However, in order to implement the present invention the cooling unit 4 is provided with a pair of openings 24 running along each side of the cooling unit, at the upper end of the cooling unit proximate the fans 10a and 10b.

The openings 24 in this preferred embodiment are louver openings, with the flaps of the louver angled upwards, to direct the flow of exhaust air as described hereinbelow.

As is best illustrated by Figure 2(b), the provision of the openings 24 in the cooling unit 4 provides an additional air flow path as represented by arrows 26 for expelling air from the cooling unit.

The sizing of the cooling unit 4 is such that it is narrower than the housing 6, and as can be seen in Figure 2(b) a chamber, indicated by the dashed line generally denoted by reference numeral 30, is formed in the space defined by the overlap of the housing 6 with the cooling unit 4. The height of the chamber 30 corresponds to the height of the cooling unit 4.

The air flow 26 flows into the chamber 30 from the cooling unit 4. The high velocity of the flow path 26 in the chamber 30, with its momentum in an outward vertical direction, results in a low pressure zone above line X-X within the chamber 30. The enhanced pressure differential across line X-X promotes an extra air flow, represented by the dashed arrow 28, to move through the fins 8 of the housing 6 below the cooling unit 4. This extra air flow 28 increases the mass of the air flow from the bottom 8 of the housing to the top, and consequently reduces the vertical temperature gradient within the housing.

Although the fins 8 provide a convenient conduit for the air flow 28, in practice it will be understood that if the extremities of the cooling unit 4 were aligned with the extremities of the housing unit 4, a low pressure zone would still exist external to the housing beneath the openings 24, which would result in an air flow such as flow 28 alongside the exterior of the housing.

Thus the openings 24 provide an accelerated exhaust flow relative to the normal exhaust flow. The accelerated exhaust flow enhances the flow of air across the outside surface of the unit. The angle of the louver openings, in the preferred embodiment, to direct the exhaust flow determines the direction in which the air-flow is enhanced.

In a preferred embodiment of the housing 6 there is provided a solar shield on the sides of the housing 6 which provide a duct to promote the air flow.

Although a pair of openings 24 are shown on two sides of the cooling unit in Figure 2(a), it will be understood that any number of openings may in fact be provided. Similarly the openings may be provided on any one of the four sides of the cooling unit.

## Claims

1. A cooling module comprising a housing having an opening in a top and a bottom thereof, a fan being provided in the top of the housing to promote the flow of air from the bottom to the top, the housing further being provided with at least one opening in a side thereof for facilitating a flow of air external to the housing, wherein a pressure differential is thereby created in a region external to the housing below the at least one opening, whereby an additional air flow is facilitated along the external side of the housing by said pressure differential.

2. The cooling module of claim 1 wherein the at least one opening provides a high velocity air flow.

3. The cooling module of claim 1 or claim 2 wherein the at least one opening is angled to provide a high velocity air flow.

4. The cooling module of any one of claims 1 to 3 wherein the at least one opening is a louver opening.

5. The cooling module of any one of claims 1 to 4 wherein the housing is provided with physical means external thereto forming a channel for the additional air flow.

6. The cooling module of claim 5 wherein the physical means comprises a series of protruding fins.

7. The cooling module of claim 5 wherein the physical means comprises a solar panel, a channel being formed between the panel and the side of the housing.
